(19) Europäisches Patentamt
European Patent Office
Office européen des brevets

(11) **EP 2 211 190 A1**

(12) **EUROPÄISCHE PATENTANMELDUNG**

(43) Veröffentlichungstag:
**28.07.2010 Patentblatt 2010/30**

(51) Int Cl.:
***G01R 31/11*** *(2006.01)*

(21) Anmeldenummer: **09015657.1**

(22) Anmeldetag: **17.12.2009**

(84) Benannte Vertragsstaaten:
**AT BE BG CH CY CZ DE DK EE ES FI FR GB GR
HR HU IE IS IT LI LT LU LV MC MK MT NL NO PL
PT RO SE SI SK SM TR**
Benannte Erstreckungsstaaten:
**AL BA RS**

(30) Priorität: **27.01.2009 DE 102009007382**

(71) Anmelder: **Hagenuk KMT Kabelmesstechnik
GmbH
01471 Radeburg (DE)**

(72) Erfinder:
• **Gray, Patrick
96199 Zapfendorf (DE)**
• **Schlapp, Hubert
96106 Ebem (DE)**

(74) Vertreter: **Hansmann, Dierk
Patentanwälte
Hansmann-Klickow-Hansmann
Jessenstrasse 4
22767 Hamburg (DE)**

(54) **Verfahren und Vorrichtung zur Kompensation von Zuleitungseinflüssen bei einer Fehlerortung**

(57)    Für eine Anwendung einer Impulsreflexionsmethode in der Kabelfehlerortung ist vorgesehen, daß ein bidirektionaler Richtkoppler (3) zur Trennung des Quellensignals vom reflektierten Signal verwendet wird. Zusätzlich wird eine Vorabmessung der Eingangsimpedanz des Meßobjekts (8) durchgeführt. Die durch diese zusätzliche Messung gewonnene Information über den Betrag des Wellenwiderstands des ersten Abschnitts des Meßobjekts wird in einem nachfolgenden Schritt der numerischen Korrektur der Impulsechomessung verwendet, um den Impedanzsprung zwischen Vormeßkabel (7) und Meßobjekt im Frequenzbereich zu kompensieren. Diese Kompensation der störenden Einflüsse und der redundanten Information bewirkt eine Verbesserung der Auswertbarkeit und verhindert somit Fehlinterpretationen, die zu falschen Schlußfolgerungen über das Meßobjekt führen. Ferner ist durch die verbesserte Auswertbarkeit der Impulsdiagramme eine schnellere Interpretation der Meßergebnisse möglich.

EP 2 211 190 A1

**Beschreibung**

Die Erfindung bezieht sich auf ein Verfahren zur Kompensation von Zuleitungseinflüssen zum Meßobjekt bei einer Fehlerortung an elektrischen Leitungen und Kabeln mit einer Längenbestimmung mittels einer Impulsreflexionsmethode über einen ausgesendeten Impuls einer Impulsquelle für einen Überschlag/Lichtbogen an der Fehlerstelle mit einer niederohmigen Impedanz sowie einer Meßwerterfassung von reflektierten Signalen, wobei das Meßobjekt über Vormeßkabel und Trennfilter mit einem Impulsreflektormeter verbunden ist.

Derartige Verfahren und Anordnungen sind bekannt, wobei ein Impulsechomeßgerät mit einer Impulsquelle und einer Meßwerterfassung zur Darstellung von gemessenen Reflexionen verwendet wird.

Im Regelfall ist das Impulsechomeßgerät in dieser Anwendung in einem Meßwagen integriert und wird über ein Vormeßkabel, das gegebenenfalls bis zu 50m lang ist, mit dem Meßobjekt verbunden. In bekannter Weise wird mit einer Hochspannungsquelle ein Verfahren ermöglicht, einen nicht festbrennbaren Fehler zu orten. Dabei wird zur Fehlerortung mit Hilfe einer Hochspannungsquelle ermöglicht, daß ein Fehler kontrolliert einen Überschlag auslöst und daraufhin mit einem Zeitbereichsreflektometer die niederohmige Impedanz des Lichtbogens am Ort des Fehlers detektiert wird. Es befindet sich bei diesem Verfahren ein Trennfilter im Ausbreitungsweg des Impulses, das die Aufgabe hat, das Zeitbereichsmeßsystem von der Hochspannungsquelle zu entkoppeln und die Impulse des Zeitbereichsmeßsystems auf das Meßobjekt zu koppeln. Dieser Trennfilter bewirkt durch seine Übertragungsfunktion eine Verfälschung des Impulsdiagramms. Dabei wird, durch die Eigenresonanz des Trennfilters, dem Impulsdiagramm eine niederfrequente Schwingung überlagert. Diese erschwert die genaue Zuordnung des Fußpunktes eines reflektierten Impulses, so daß ein Fehler in der Laufzeitbestimmung entsteht.

Zusätzlich kommt für die Auswertung der resultierenden Impulsdiagramme hinzu, daß der Wellenwiderstand des Vormeßkabels in der Regel nicht der Eingangsimpedanz des Meßobjekts entspricht, und somit eine Reflexion des Eingangssignals an dieser Stelle entsteht. Diese Reflexion hat im Impulsdiagramm aber für den Nutzer des Systems keinen Informationsgehalt und erschwert durch Mehrfachreflexionen zwischen dieser - und nachfolgenden Impedanzsprungstellen die Interpretierbarkeit der Messungen.

Aufgabe der Erfindung ist es, ein Verfahren und eine Vorrichtung zu schaffen, die die Auswertbarkeit von Meßdaten, die mit einem Zeitbereichsreflektometer gemessen wurden, zu steigern, bzw. zu vereinfachen und die störenden Einflüsse, die sich zwischen der Meßwerterfassung und dem eigentlichen Meßobjekt befinden, zu korrigieren. Darüber hinaus ist beabsichtigt, die Wahrscheinlichkeit der Erkennung von Fehlern, die sich im Nahbereich der Meßstelle befinden zu erhöhen.

Die Lösung dieser Aufgabe erfolgt durch die Verfahrensschritte gemäß Patentanspruch 1.

Eine Vorrichtung zur Durchführung des Verfahrens besteht darin, daß ein bidirektionaler Richtkoppler über Schalter zur Trennung der vor- und zurücklaufenden Signale eingeschaltet ist und eine Recheneinheit als Auswerteelement zur Ermittlung eines komplexen Reflektionsfaktors über getrennte Kanäle (Ch1, Ch2) einer Meßwerterfassung zuführbar ist, wobei die Signale mit einer numerischen Implementation der Fouriertransformation in den Frequenzbereich transformierbar sind und/oder über eine Kalibrierung im Frequenzbereich von den Einflüssen des Vormeßkabels und Trennfilters befreit der Meßwerterfassung zuführbar ist.

Hierdurch wird eine Kompensation der störenden Einflüsse der redundanten Informationen bewirkt und eine Verbesserung der Auswertbarkeit erzielt sowie Fehlinterpretationen, die zu falschen Schlußfolgerungen über das Meßobjekt führen, verhindert. Außerdem ist durch die verbesserte Auswertbarkeit der Impulsdiagramme eine schnellere Interpretation der Meßergebnisse möglich.

Ferner ist vorgesehen, daß ein Speicher der Recheneinheit zugeordnet ist, der eine Datenbank mit Impulsdiagrammen aufweist, die durch Messungen mit unterschiedlichen diskreten Widerständen von Eingangsimpedanzen der Meßobjekte ermittelt wurden.

Eine vorteilhafte Anordnung wird dadurch gebildet, daß die Einflüsse von Trennfilter und Vormeßkabel in einem Fehler-Zweitor zusammengefaßt sind.

In der Zeichnung sind Darstellungen zur Erläuterung der Erfindung schematisch aufgezeigt. Es zeigen:

Fig.1 eine Schaltungsanordnung zur Aufrichtung von vor- und rücklaufenden Signalen für ein Impulsreflexionsverfahren;

Fig. 2 Schaltungsanordnung zur Erklärung einer Berechnung der Fehlerterme,

Fig. 3 ein gemessenes Sprungspannungsdiagramm bei einer Eingangsimpedanzmessung,

Fig. 4 schematische Darstellung des Verfahrens mit Impulsdiagramm eines Kabels mit Fehler nach dem Stand der Technik,

Fig. 5    eine Darstellung gemäß Fig. 4 entsprechend der Erfindung,

Fig. 6    eine Darstellung eines Meß-Diagramms des Impulsmeßgerätes nach dem Stand der Technik gemäß Fig. 4 und

Fig. 7    eine Darstellung wie Fig. 6 entsprechend der Erfindung gemäß Fig. 5.

Die dargestellte Schaltungsanordnung dient zur Realisierung des durchzuführenden Verfahrens. Hierbei stellt ein bidirektionaler Richtkoppler 3 ein zentrales Element der Schaltungsanordnung dar. Dieser Richtkoppler 3 ermöglicht eine Signaltrennung in vor- und zurücklaufendes Signal und führt dieses zu einem Schaltungselement zur Meßwerterfassung 4.

Hierzu wird ein Teil eines von einer Impulsquelle 1 ausgesendeten Impulses vom Richtkoppler 3 an den Kanal 1 (Ch1) gekoppelt, während der größte Teil der Sendeleistung durch den Richtkoppler 3 auf ein Vormeßkabel 7 und somit auf ein Meßobjekt 8 als Kabel gegeben wird. Die Reflexionen aus dem Meßobjekt 8 bzw. vom Übergang des Vormeßkabels 7 auf das Meßobjekt 8 werden vom Richtkoppler 3 an einen Kanal 2 (Ch2) der Meßwerterfassung 4 gekoppelt. Diese Aufteilung in ein vor- und rücklaufende Signal ermöglicht die Berechnung eines komplexen Reflexionsfaktors $r_m$, wenn man die gemessenen Signale mit der numerischen Implementation der Fouriertransformation in den Frequenzbereich transformiert.

$$r_m = \frac{U_r(f)}{U_i(f)}$$

Der komplexe Reflexionsfaktor wird dann mit Hilfe eines als Eintor-Kalibrierung bekannten Verfahrens im Frequenzbereich von den Einflüssen des Vormeßkabels 7 und eines Trennfilters 6 befreit.

Die Eintor-Kalibrierung ist in der HF-Technik ein standardisiertes Mittel um Netzwerk-Analysatoren zu kalibrieren und die Fehler, die durch die Zuleitungen und die Meßfassungen verursacht werden, zu kompensieren.

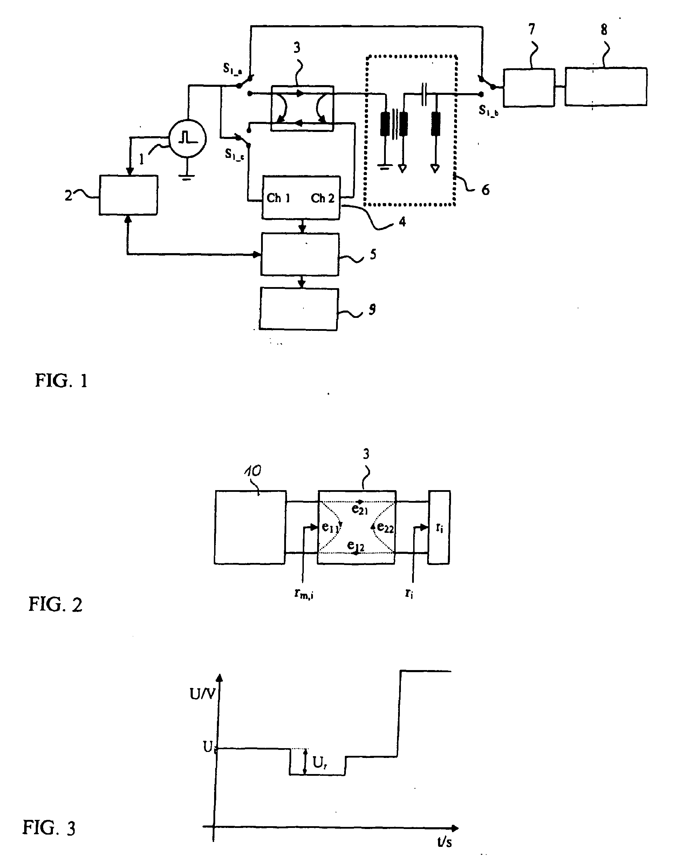

In einem hier betrachteten Beispiel sind die Einflüsse des Trennfilters 6 und des Vormeßkabels 7 in einem Fehler-Zweitor zusammengefaßt. Im Folgenden wird der Ablauf bei dieser Kalibrierung erläutert, wobei auf die Anordnung gemäß Fig. 2 verwiesen wird. Hierbei ist der Meßaufbau einer Reflexionsfaktormessung mit einer Signalquelle 10 schematisch dargestellt. Das Meßobjekt r soll charakterisiert werden. Jedoch verfälscht das Fehler-Zweitor mit den Streuparametern $e_{11}$, $e_{21}$, $e_{12}$ und $e_{22}$ die Messung. Somit mißt man anstelle des gewünschten Reflexionsfaktors $r_i$ den fehlerbehafteten $r_{m,i}$.

$$r_{m,i} = e_{11} + \frac{e_{21}e_{12}r_i}{1 - e_{22}r_i}.$$

Durch Umstellen der Gleichung ergibt sich folgender linearer Ausdruck der von drei Unbekannten abhängig ist.

$$r_{m,i} = e_{11} + e_{22}r_i r_{m,i} - \Delta E r_i$$

mit

$$\Delta E = e_{11}e_{22} - e_{21}e_{12}$$

Werden drei bekannte Standards benutzt, die nacheinander an den Ausgang des fehlerbehafteten Zweitors angeschlossen werden, erhält man ein vollständig lösbares Gleichungssystem. Hierbei werden in der Regel Kurzschluß, Leerlauf und angepaßter Abschluß mit dem Wellenwiderstand der Zuleitung verwendet.

$$\begin{pmatrix} r_{m,1} \\ r_{m,2} \\ r_{m,3} \end{pmatrix} = \begin{bmatrix} 1 & r_1 r_{m,1} & -r_1 \\ 1 & r_2 r_{m,2} & -r_2 \\ 1 & r_3 r_{m,3} & -r_3 \end{bmatrix} \begin{pmatrix} e_{11} \\ e_{22} \\ \Delta E \end{pmatrix}$$

Mit diesen idealen Standards sind die Reflexionsfaktoren $r_1 = r_{KS} = -1$, $r_2 = r_{LL} = 1$ und $r_3 = r_{angepasst} = 0$ im Gleichungssystem einzusetzen. Mit den entsprechenden Meßwerten $r_{m,1}$, $r_{m,2}$ und $r_{m,3}$ folgt als Lösung des Gleichungssystems $e_{11}$, $e_{22}$ und $\Delta E$.

Die Fehlerfaktoren ergeben sich nach dem Lösen des Gleichungssystems zu

$$e_{11} = r_{m,3}$$

$$e_{22} = \frac{r_{m,1} + r_{m,2} - 2\,r_{m,3}}{r_{m,2} - r_{m,1}}$$

$$\Delta E = r_{m,3} - r_{m,2} + r_{m,2} \frac{r_{m,1} + r_{m,2} - 2\,r_{m,3}}{r_{m,2} - r_{m,1}}$$

Dadurch sind alle weiteren Meßwerte $r_m$ mit folgender Gleichung korrigierbar und das Fehler-Zweitor, bzw. den Einfluß des Vormeßkabels und des Trennfilters 6 kompensieren.

$$r = \frac{e_{11} - r_m}{\Delta E - e_{22} r_m}$$

Anschließend wird der im Frequenzbereich vorliegende Reflexionsfaktor r in den Zeitbereich zurück transformiert, um ein korrigiertes Impulsdiagramm zu erhalten.

Die Anwendung der Eintor-Kalibrierung alleine korrigiert zwar den Einfluß des Trennfilters 6 im Impulsdiagramm, die Reflexion der Impedanzsprungstelle vom Vormeßkabel 7 zum Meßobjekt 8 ist jedoch trotzdem vorhanden. Hier kann man die Eintor-Kalibrierung nutzen um diese Reflexion zu unterdrücken, indem man anstelle mit dem Wellenwiderstand des Vormeßkabels 7, mit dem Eingangswiderstand des Meßobjekts 8 kalibriert. Dadurch wird die Impedanzsprungstelle zwischen Vormeßkabel 7 und Meßobjekt 8 als systematischer Fehler interpretiert und durch die Korrekturfaktoren kompensiert. Im resultierenden Impulsdiagramm ist die Reflexion nun nicht mehr zu sehen.

Prinzipiell gliedert sich das Verfahren in zwei Schritte. Zuerst wird die Messung der Eingangsimpedanz des Meßobjekts 8 durchgeführt. Danach die eigentliche Fehlerortung mit einer Impulsechomessung. Diese wird anschließend mit der im ersten Schritt gewonnenen Information über den Eingangswiderstand des Meßobjekts 8 in der Recheneinheit 5 zur Auswertung korrigiert.

Für die Messung der Eingangsimpedanz befindet sich die Schaltungsanordnung in der dargestellten Schalterkonfiguration. D.h. Schalter $S_{1\_a}$, $S_{1\_b}$ und $S_{1\_c}$ befinden sich in der gezeigten Schalterstellung und überbrücken somit das Trennfilter 6 und den bidirektionalen Richtkoppler 3.

Der Kanal 1 (Ch1) der Meßwerterfassung 4 ist direkt an die Leitung zum Vormeßkabel 7 geschaltet und nimmt somit das Eingangssignal und das vom Vormeßkabel 7 und Meßobjekt 8 reflektierte Signal auf.

Die Impulsquelle 1 muß für diese Messung einen Spannungssprung mit moderater Ausgangsspannung liefern, um den Kanal 1 (Ch1) nicht zu übersteuern.

In Fig. 3 ist eine resultierende Spannungsmessung am Kanal 1 bei der Eingangsimpedanzmessung schematisch dargestellt. Aus dem gemessenen Spannungsverlauf wird mit folgender Formel die Eingangsimpedanz des ersten Impedanzsprungs berechnen.

$$Z_{in} = Z_0 \left( \frac{1 + \dfrac{U_r}{U_i}}{1 - \dfrac{U_r}{U_i}} \right)$$

Mit der Information über den Wert der Eingangsimpedanz kann nun der entsprechende Datensatz aus einer Datenbank 2 ausgelesen werden. In dieser Datenbank sind abhängig von der eingestellten Pulsbreite und vom angeschlossenen Eingangswiderstand Impulsdiagramme hinterlegt. Diese Impulsdiagramme werden durch die Messungen zur Kalibrierung vor dem eigentlichen Betrieb des Gerätes aufgenommen, die mit verschiedenen diskreten Widerständen am Ende des Vormeßkabels gewonnen werden. Diese diskreten Widerstände stellen Modelle der möglichen Eingangsimpedanzen des Meßobjekts 8 dar. Zusätzlich sind vor dem eigentlichen Betrieb des Gerätes Messungen mit kurzgeschlossenem Ende des Vormeßkabels 7 und mit offenem Ende im Speicher 2 hinterlegt. Für die folgenden Impulsechomessungen können anhand dieses Datensatzes die Korrekturfaktoren in der Recheneinheit 5 berechnet werden.

In dem zweiten Schritt des Verfahrens wird eine Impulsechomessung durchgeführt. Zu diesem Zweck sind die Schalter $S_{1\_a}$, $S_{1\_b}$ und $S_{1\_c}$ umzuschalten, so daß die Impulsquelle 1 an den Eingang des Richtkopplers 3 geschaltet ist. Außerdem wird damit der Kanal 1 (Ch1) an den Koppelausgang des Richtkopplers 3 geschaltet und das Vormeßkabel 7 an das Trennfilter 6. Die Impulsquelle 1 sendet nun einen Impuls über den bidirektionalen Richtkoppler 3 und das Vormeßkabel 7 auf das Meßobjekt 8. Hierbei wird ein Teil der Impulsleistung des Sendeimpulses vom bidirektionalen Richtkoppler 3 auf den Kanal 1 (Ch1) der Meßwerterfassung 4 ausgekoppelt und dort digitalisiert. Die Impulse die vom Meßobjekt 8 reflektiert werden, gelangen über den bidirektionalen Richtkoppler 3 auf den Kanal 2 (Ch2) der Meßwerterfassung 4.

Daraufhin folgt die sogenannte Eintor-Kalibrierung im Frequenzbereich. Dazu werden die vorher gemessenen Impulsdiagramme, bzw. die aus dem Speicher 2 abgerufenen Impulsverläufe und die zugehörigen Sendeimpulsmessungen in den Frequenzbereich transformiert. Anschließend werden die komplexen Reflexionsfaktoren $r_m$ berechnet und mit deren Hilfe die Eintor-Kalibrierung durchgeführt. Die Korrekturfaktoren werden auf der Grundlage der Datensätze der Kurzschluß- und der Leerlaufmessung, sowie den von dem Speicher 2 als Datenbank abgerufenen berechnet. Die so gewonnenen Korrekturfaktoren werden benutzt um den manipulierten Datensatz im Frequenzbereich zu korrigieren. Die anschließende Rücktransformation in den Zeitbereich ermöglicht eine Darstellung des gewohnten Impulsdiagramms im Impulsechomeßgerät 9. Das nun dargestellte Impulsdiagramm ist befreit von den störenden Einflüssen des Filters 6, des Vormeßkabels 7 und der Sprungstelle zwischen Vormeßkabel 7 und Meßobjekt 8.

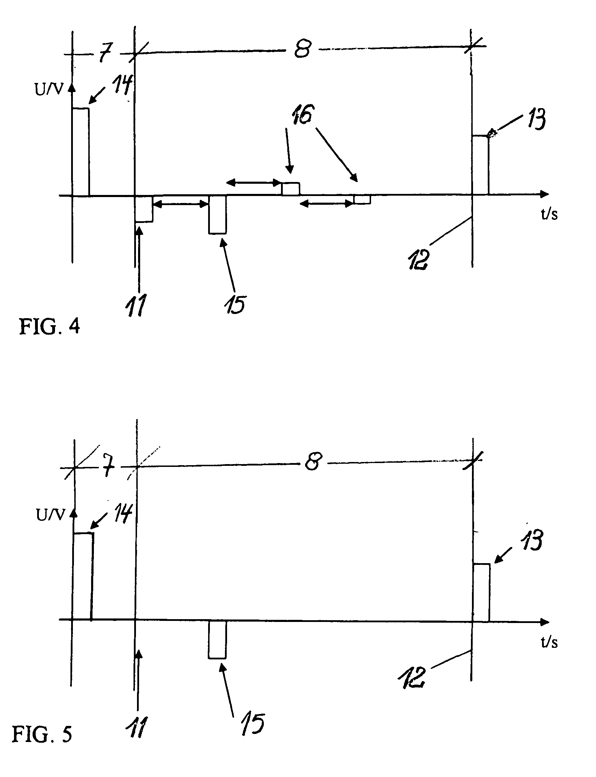

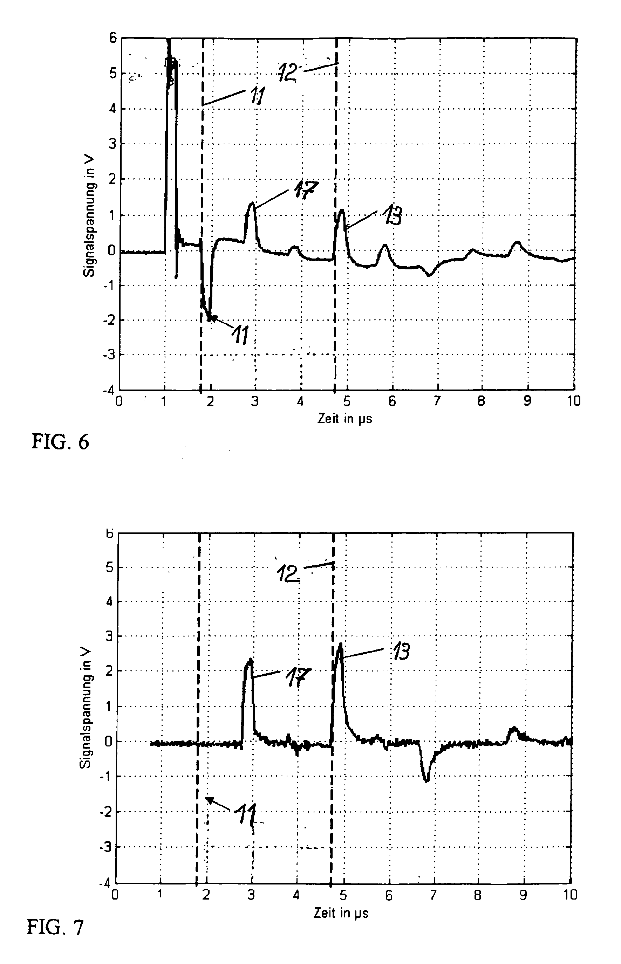

Gemäß Fig. 4 und 6 ist nochmals das Verfahren mit Diagrammen nach dem Stand der Technik und entsprechend Fig. 5 und 7 unter Berücksichtigung des vorgeschlagenen Verfahrens und Schaltungsanordnung dargestellt. Hierbei ist eine Referenzebene 11 zwischen Vormeßkabel 7 und Meßgerät 8 als Kabel eingezeichnet. Ferner ist das offene Ende des Meßobjektes 8 als Ebene 12 mit einer zugeordneten Reflexion 13 dargestellt.

Weiterhin ist der Sendeimpuls 14 bezeichnet sowie ein Fehler 15 im Meßobjekt 8 sowie Mehrfachreflexionen 16 durch Kabelveränderungen. Zusätzlich ist ein Reflexionsimpuls 17 des Überganges von Vormeßkabel 7 und Kabel 8 in Fig. 4 und 6 dargestellt.

**Patentansprüche**

1. Verfahren zur Kompensation von Zuleitungseinflüssen zum Meßobjekt bei einer Fehlerortung an elektrischen Leitungen und Kabeln mit einer Längenbestimmung mittels einer Impulsreflexionsmethode über einen ausgesendeten Impuls einer Impulsquelle für einen Überschlag/Lichtbogen an der Fehlerstelle mit einer niederohmigen Impedanz sowie einer Meßwerterfassung von reflektierten Signalen, wobei das Meßobjekt über Vormeßkabel und Trennfilter mit einem Impulsreflektormeter verbunden ist, **gekennzeichnet durch** folgende Verfahrensschritte

- Impedanzmessung des Meßobjektes;
- zeitbereichsreflexionsmessung mit Trennung von vor- und zurücklaufendem Signal **durch** einen bidirektionalen Richtkoppler;
- Verarbeitung der Daten aus Impedanzmessung und vor- und zurücklaufenden Signalen in einer Recheneinheit;
- Ermittlung eines komplexen Reflektionsfaktors **durch** Aufteilung von vor- und zurücklaufendem Signal, wobei die gemessenen Signale mit einer numerischen Implementation der Fouriertransformation in den Frequenzbereich transportiert werden;
- Befreiung des komplexen Reflektionsfaktors mittels Kalibrierung im Frequenzbereich von Einflüssen des Vormeßkabels und des Trennfilters;
- Zuführung der korrigierten Daten zur Meßwerterfassung.

2. Vorrichtung zur Durchführung des Verfahrens zur Fehlerortung an Leitungen und Kabel gemäß Anspruch 1 nach der Impulsreflektionsmethode und Anschluß des Meßobjektes über ein Vormeßkabel und Trennfilter, **dadurch gekennzeichnet, daß** ein bidirektionaler Richtkoppler (3) über Schalter (5) zur Trennung der vor- und zurücklaufenden Signale eingeschaltet ist und eine Recheneinheit (5) als Auswerteelement zur Ermittlung eines komplexen Reflektionsfaktors über getrennte Kanäle (Ch1, Ch2) einer Meßwerterfassung zuführbar ist, wobei die Signale mit einer numerischen Implementation der Fouriertransformation in den Frequenzbereich transformierbar sind und/oder über eine Kalibrierung im Frequenzbereich von den Einflüssen des Vormeßkabels (7) und Trennfilters (6) befreit der Meßwerterfassung (9) zuführbar ist.

3. Vorrichtung nach Anspruch 2, **dadurch gekennzeichnet, daß** ein Speicher (2) der Recheneinheit (5) zugeordnet ist, der eine Datenbank mit Impulsdiagrammen aufweist, die durch Messungen mit unterschiedlichen diskreten Widerständen von Eingangsimpedanzen der Meßobjekte (8) ermittelt wurden.

4. Vorrichtung nach einem der Ansprüche 2 oder 3,
**dadurch gekennzeichnet, daß** die Einflüsse von Trennfilter (6) und Vormeßkabel (7) in einem Fehler-Zweitor zusammengefaßt sind.

FIG. 1

FIG. 2

FIG. 3

FIG. 4

FIG. 5

FIG. 6

FIG. 7

Europäisches
Patentamt

European
Patent Office

Office européen
des brevets

**EUROPÄISCHER RECHERCHENBERICHT**

Nummer der Anmeldung

EP 09 01 5657

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | EP 0 148 674 A1 (BALTEAU SA [BE]) 17. Juli 1985 (1985-07-17) * Zusammenfassung; Abbildungen 1,4 * * Seite 7, Zeile 5 - Zeile 7 * ----- | 1-4 | INV. G01R31/11 |
| A | BOETS P ET AL: "Non-parametric calibration of a time domain reflectometer" INSTRUMENTATION AND MEASUREMENT TECHNOLOGY CONFERENCE, 1994. IMTC/94. CONFERENCE PROCEEDINGS. 10TH ANNIVERSARY. ADVANCED TECHNOLOGIES IN I & M., 1994 IEEE HAMAMATSU, JAPAN 10-12 MAY 1994, NEW YORK, NY, USA,IEEE LNKD-DOI:10.1109/IMTC.1994.352113, 10. Mai 1994 (1994-05-10), Seiten 114-117, XP010122026 ISBN: 978-0-7803-1880-9 * Zusammenfassung; Abbildungen 1-3 * * Seite 114, linke Spalte - rechte Spalte, Absatz 2 * * Seite 114, rechte Spalte, Absatz 4 * * Seite 115, rechte Spalte, letzter Absatz - Seite 116, linke Spalte, Absatz 2 * ----- | 1-4 | |
| Y | EP 1 411 361 A1 (CIT ALCATEL [FR]) 21. April 2004 (2004-04-21) * Zusammenfassung; Ansprüche 1,2; Abbildungen 1,3 * * Absatz [0017] - Absatz [0022] * * Absatz [0045] - Absatz [0054] * * Absätze [0061], [0083] * ----- | 1-4 | RECHERCHIERTE SACHGEBIETE (IPC) G01R H04B |
| A | US 6 437 578 B1 (GUMM LINLEY F [US]) 20. August 2002 (2002-08-20) * Zusammenfassung; Abbildungen * ----- | 1,2 | |
| | -/-- | | |

Der vorliegende Recherchenbericht wurde für alle Patentansprüche erstellt

| Recherchenort | Abschlußdatum der Recherche | Prüfer |
|---|---|---|
| Berlin | 21. Mai 2010 | Fritz, Stephan C. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

Europäisches
Patentamt

European
Patent Office

Office européen
des brevets

**EUROPÄISCHER RECHERCHENBERICHT**

**Nummer der Anmeldung**

EP 09 01 5657

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | WO 03/040736 A1 (AWARE INC [US]) 15. Mai 2003 (2003-05-15) * Zusammenfassung; Abbildungen * ----- | 1,2 | |

RECHERCHIERTE SACHGEBIETE (IPC)

Der vorliegende Recherchenbericht wurde für alle Patentansprüche erstellt

| Recherchenort | Abschlußdatum der Recherche | Prüfer |
|---|---|---|
| Berlin | 21. Mai 2010 | Fritz, Stephan C. |

KATEGORIE DER GENANNTEN DOKUMENTE

X : von besonderer Bedeutung allein betrachtet
Y : von besonderer Bedeutung in Verbindung mit einer
 anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
 nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
 Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**                    EP 09 01 5657

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

21-05-2010

| Im Recherchenbericht angeführtes Patentdokument | | Datum der Veröffentlichung | Mitglied(er) der Patentfamilie | | Datum der Veröffentlichung |
|---|---|---|---|---|---|
| EP 0148674 | A1 | 17-07-1985 | DE | 3469320 D1 | 17-03-1988 |
|  |  |  | FR | 2557980 A1 | 12-07-1985 |
| EP 1411361 | A1 | 21-04-2004 | AT | 321273 T | 15-04-2006 |
|  |  |  | DE | 60210031 T2 | 09-11-2006 |
|  |  |  | ES | 2256428 T3 | 16-07-2006 |
|  |  |  | US | 2004080323 A1 | 29-04-2004 |
| US 6437578 | B1 | 20-08-2002 | KEINE |  |  |
| WO 03040736 | A1 | 15-05-2003 | KEINE |  |  |

EPO FORM P0461

Für nähere Einzelheiten zu diesem Anhang : siehe Amtsblatt des Europäischen Patentamts, Nr.12/82